# EUROPEAN PATENT APPLICATION

(11) **EP 4 848 915 A1**
(43) Date of publication of application: **02.12.2026**
(21) Application number: 26174758.8
(22) Date of filing: 27.04.2026
(51) Int. Cl.: H05K 7/14

(54) **SEMICONDUCTOR MODULE ARRANGEMENT**

(30) Priority: 06.05.2025 US 202563800647 P; 27.06.2025 US 202519252244
(71) Applicant: Infineon Technologies AG, 85579 Neubiberg (DE)
(72) Inventor: NOLTEN, Ulrich, 59602 Rüthen (DE); MÜLLER, Christian, 97424 Schweinfurt (DE); DITZ, Michael, 59939 Olsberg (DE)
(74) Representative: Westphal, Mussgnug & Partner, Patentanwälte mbB

(57) **Abstract**

A semiconductor module arrangement includes a housing, a first substrate positioned at a bottom of the housing, a busbar arrangement, and a first connectional component. The busbar arrangement has a first end connected to the first substrate, a second end extending outside the housing, and a middle portion spaced from and extending parallel to the first substrate. The middle portion of the busbar arrangement includes an opening extending therethrough. The first connectional component has a first end connected to the first substrate, a second end extending outside the housing, and a middle portion extending through the opening in the middle portion of the busbar arrangement.

## Description

This application is a Continuation Application of U.S. Provisional Application No. 63/800,647, filed May 6, 2025, which is incorporated by reference herein in its entirety.

### TECHNICAL FIELD

The instant disclosure relates to an internal busbar arrangement for a semiconductor module.

### BACKGROUND

In a typical semiconductor power module, power substrates are located on a base plate at the bottom of the module housing. Low-inductance modules require close, parallel routing of the DC busbars inside and outside the module. To facilitate placement of a driver directly on top of the module, e.g., via a printed circuit board (PCB), these busbars may be vertically stacked in parallel with adequate spacing and insulation between the busbars. The internal busbars are typically routed from one side of the module, where they are configured to be connected to an external busbar by a customer, to the center of the module in connection with the power substrates. In this way, the DC terminals are arranged so as not to interfere with a top-mounted PCB. However, this means that one of the two power substrates is covered by the internal busbar arrangement, thereby limiting the space available for placement of control contacts, such as vertically extending pins. This may lead to asymmetrical control of the chips (dies) on the affected substrate. This is particularly relevant if the control contacts are implemented either directly or via a pin-sleeve construction.

Because the internal DC busbar arrangement only spans one substrate, this results in an asymmetry of the switching behavior between high-side and low-side switches when using a half-bridge topology, in which the high-side switches are mounted to one substrate and the low-side switches are mounted to the other substrate.

There is a need for an internal busbar arrangement in which there is more flexibility in the positioning of control contacts or other structures in semiconductor power modules with laterally extending internal busbars.

### SUMMARY

According to an embodiment of a semiconductor module arrangement, the semiconductor module arrangement comprises: a housing; a first substrate positioned at a bottom of the housing; a busbar arrangement having a first end connected to the first substrate, a second end extending outside the housing, and a middle portion spaced from and extending parallel to the first substrate, the middle portion comprising an opening extending therethrough; and a first connectional component having a first end connected to the first substrate, a second end extending outside the housing, and a middle portion extending through the opening in the middle portion of the busbar arrangement.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a side cross-sectional view of a semiconductor module arrangement having a busbar arrangement with an opening that enables symmetric switching behavior.
FIG. 2 illustrates a top plan view of the semiconductor module arrangement.
FIG. 3 illustrates a side cross-sectional view of the semiconductor module arrangement in a region of the opening in the busbar arrangement.
FIG. 4 illustrates a top perspective view of the semiconductor module arrangement in the region of the opening in the busbar arrangement.
FIG. 5 illustrates a top plan view of a substrate that underlies the busbar arrangement.
FIG. 6 illustrates a top plan view of a module substrate with one-sided contacting.
FIG. 7 illustrates a side perspective view of the busbar arrangement.

### DETAILED DESCRIPTION

Embodiments described herein include a semiconductor module arrangement having a housing, at least one substrate positioned at a bottom of the housing, a busbar arrangement, and at least one connectional component. A middle portion of the busbar arrangement is spaced from and extends parallel to the substrate, and has an opening extending therethrough. The connectional component extends upward through the opening in the middle portion of the busbar arrangement, for later connection to an external PCB or other component such as another semiconductor module arrangement. Each sidewall that delimits the opening in the busbar arrangement may comprise an electrically insulative material, for example, by overmolding the region of the busbar opening with plastic so that insulation requirements (accounting for both clearance and creepage distances) are maintained. This way, the insulation requirements are satisfied while also providing a more symmetrical pathway for power, control and/or reference signals to be routed to the module, e.g., such that the load currents are divided symmetrically within the busbar arrangement and flow around the opening.

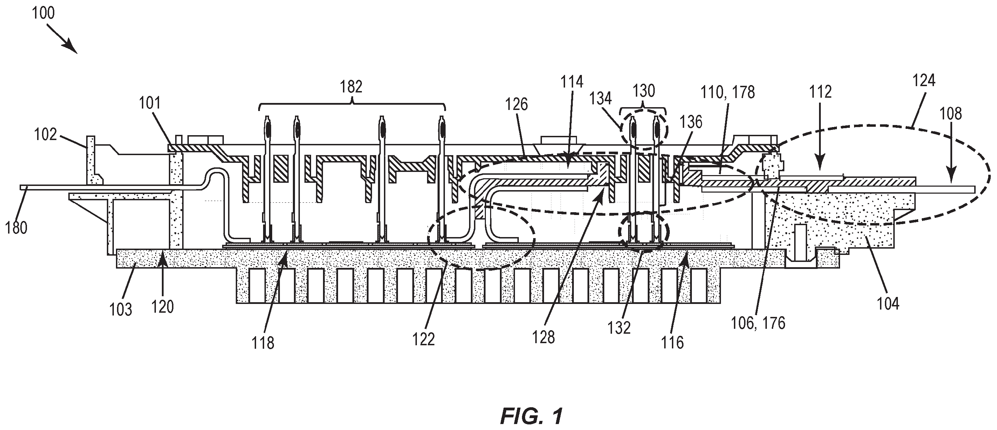

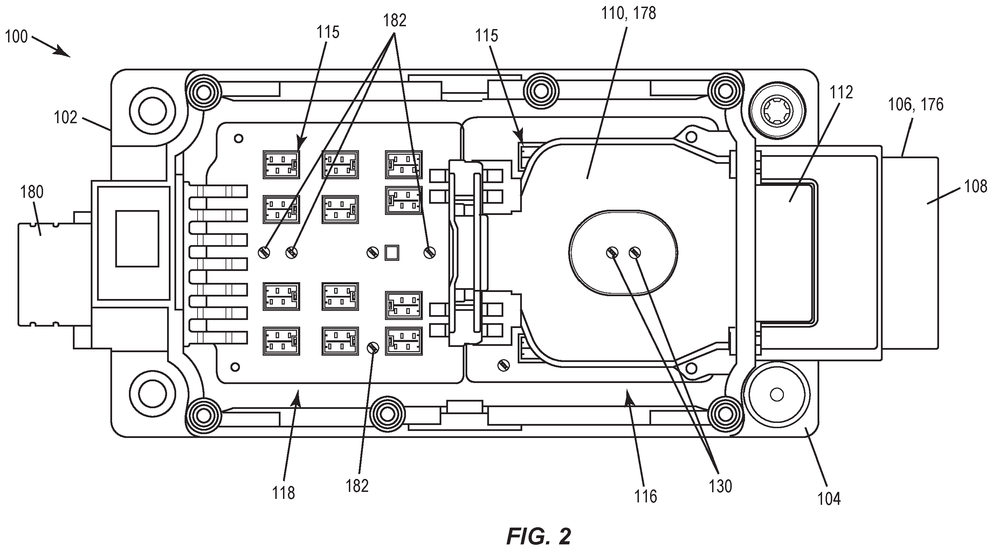

FIG. 1 illustrates a cross-sectional side view of a semiconductor module arrangement 100 and FIG. 2 illustrates a top plan view of the semiconductor module arrangement 100, according to an embodiment. In FIG. 2, the semiconductor module arrangement 100 is shown without a cover so that the internal components are visible. The semiconductor module arrangement 100 may or may not have a cover at the module topside.

The semiconductor module arrangement 100 includes a housing 102 that comprises an electrically insulative enclosure 104, a first (lower) busbar 106 having a first contact surface 108 exposed outside the enclosure 104, and a second (upper) busbar 110 having a second contact surface 112 above the first contact surface 108 and exposed outside the enclosure 104. The busbars 106, 110 are vertically stacked in parallel as part of a busbar arrangement 114, to reduce stray inductance L_{σ}. The busbar arrangement 114 provides external power connections via the respective busbar contact surfaces 108, 112 exposed outside the enclosure 104, and carries corresponding electrical power signals (e.g., DC+ and DC-) inside the enclosure 104 to one or more power semiconductor devices 115 housed in the enclosure 104.

The semiconductor devices 115 form all or part of a power circuit, such as a DC/AC inverter, a DC/DC converter, an AC/DC converter, a DC/AC converter, an AC/AC converter, a multiphase inverter, an H-bridge, motor driver, etc. In some examples, the circuit is a half-bridge or full-bridge circuit. The semiconductor devices 115 may be, e.g., SiC transistor dies such as SiC power MOSFET (metal-oxide-semiconductor field-effect transistor) dies, Si power MOSFET dies, HEMT (high-electron mobility transistor) dies, IGBT (insulated-gate bipolar transistor) dies, JFET (junction filed-effect transistor) dies, etc. The semiconductor devices 115 may be attached to one or more substrates 116, 118 positioned at the bottom 120 of the housing 102, e.g., such as a DCB (direct copper bonded) or AMB (active metal brazed) substrate, printed circuit board (PCB), lead frame, insulated metal substrate (IMS), etc.

As explained above, the busbar arrangement 114 carries corresponding electrical power signals inside the enclosure 104 to the one or more power semiconductor devices 115 housed within the enclosure 104. For example, one of the busbars 106, 110 may be at a positive DC potential (DC+) and the other one of the busbars 106, 110 may be at a negative DC potential (DC-). The busbars 106, 110 are vertically stacked one above the other, to reduce stray inductance L_{σ}.

A first (proximal) end 122 of the busbar arrangement 114 is connected to the one or more substrates 116, 118 positioned at the bottom 120 of the housing 102. A second (distal) end 124 of the busbar arrangement 114 extends outside the housing 102 and includes the exposed contact surfaces 108, 112. A middle portion 126 of the busbar arrangement 114 is spaced from and extends parallel to the substrate 116 underlying the busbar arrangement 114. The middle portion 126 of the busbar arrangement 114 has at least one opening 128 extending therethrough.

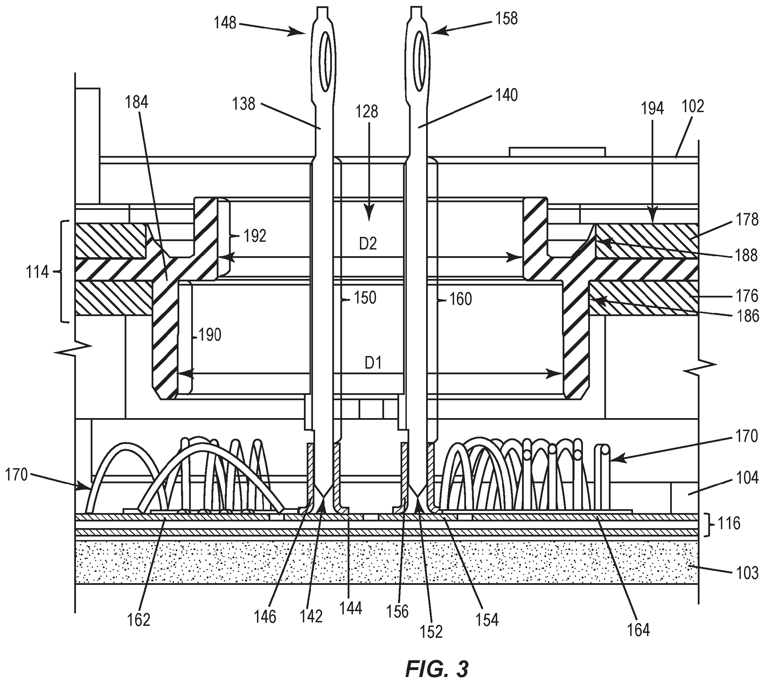

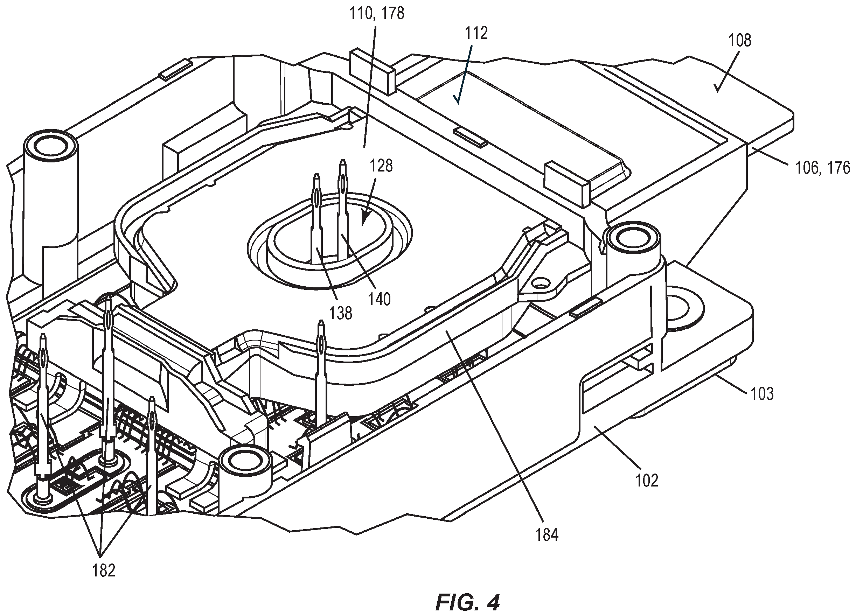

FIG. 3 illustrates a cross-sectional side view of the semiconductor module arrangement 100 in a region of the opening 128 in the busbar arrangement 114. FIG. 4 illustrates a top perspective view of the semiconductor module arrangement 100 in the region of the opening 128 in the busbar arrangement 114.

A first connectional component 130 vertically extends through the opening 128 in the busbar arrangement 114. The first connectional component 130 provides at least one additional point of external electrical contact for the semiconductor module arrangement 100. For example, the first connectional component 130 may carry a control (e.g., gate) signal and/or a reference (e.g., source or emitter) signal to the semiconductor devices 115 attached to the substrate 116 underlying the busbar arrangement 114.

A first (proximal) end 132 of the first connectional component 130 is connected to the substrate 116 underlying the busbar arrangement 114. A second (distal) end 134 of the first connectional component 130 extends outside the housing 102. A middle portion 136 of the first connectional component 130 vertically extends through the opening 128 in the middle portion 126 of the busbar arrangement 114.

The first connectional component 130 is illustrated as including a first pin-type terminal 138 and a second pin-type terminal 140. Each of the pin-type terminals 138, 140 may be connected to the substrate 116 underlying the busbar arrangement 114 by a press-fit or soldered connection, although other means of attaching the pin-type terminals 138, 140 to the substrate 116 underlying the busbar arrangement 114 are contemplated. Other types of connectional components are contemplated, too, such as a metallic clips, a flex PCB, etc.

Returning to the pin-type terminal example for the first connectional component 130, a first (proximal) end 142 of the first pin-type terminal 138 is connected to a first intermediary metallized section 144 of the substrate 116 underlying the busbar arrangement 114. For example, the proximal end 142 of the first pin-type terminal 138 may be attached to the first intermediary metallized section 144 of the substrate 116 underlying the busbar arrangement 114, or received in a metallic sleeve 146 attached to the first intermediary metallized section 144. A second (distal) end 148 of the first pin-type terminal 138 extends outside the housing 102. A middle portion 150 of the first pin-type terminal 138 extends through the opening 128 in the middle portion 126 of the busbar arrangement 114.

A first (proximal) end 152 of the second pin-type terminal 140 is connected to a second intermediary metallized section 154 of the substrate 116 underlying the busbar arrangement 114, where the first intermediary metallized section 144 and the second intermediary metallized section 154 are electrically isolated from one another in this example. The proximal end 152 of the second pin-type terminal 140 may be attached to the second intermediary metallized section 154 of the substrate 116 underlying the busbar arrangement 114, or received in a metallic sleeve 156 attached to the second intermediary metallized section 154. A second (distal) end 158 of the second pin-type terminal 140 extends outside the housing 102. A middle portion 160 of the first pin-type terminal 138 extends through the opening 128 in the middle portion 126 of the busbar arrangement 114.

The opening 128 in the busbar arrangement 114 results in a slight increase in leakage inductance in the load circuit, but is accepted to achieve symmetrical switching behavior. Symmetrical switching behavior is realized by connecting the first connectional component to the substrate 116 underlying the busbar arrangement 114 through the opening 128 in the busbar arrangement 114. The first connectional component 130 may carry a control (e.g., gate) signal and/or a reference (e.g., source or emitter) signal to the semiconductor devices 115 attached to the substrate 116 underlying the busbar arrangement 114, to actuate (turn on and off) the devices 115. The opening 128 in the busbar arrangement 114 allows for connection of the first connectional component 130 to a central metallized part of the substrate 116 underlying the busbar arrangement 114, providing for a more symmetrical distribution of the control and reference signals to the semiconductor devices 115 attached to metallized sections 162, 164 of the substrate 116 underlying the busbar arrangement 114 that flank the central metallized part of the substrate 116.

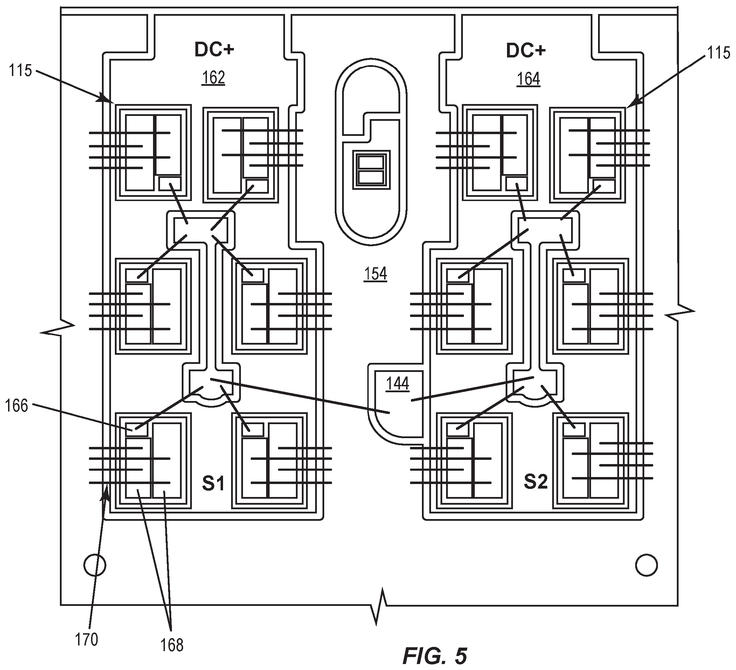

For example, FIG. 5 illustrates a top plan view of the substrate 116 that underlies the busbar arrangement 114. In FIG. 5, the first and second intermediary (central) metallized sections 144, 154 of the substrate 116 underlying the busbar arrangement 114 are symmetrically flanked by first and second additional metallized sections 162, 164 of the substrate 116. The busbar arrangement 114 is not shown in FIG. 5, to provide an unobstructed view of the underlying substrate 116. With the busbar arrangement 114 in its final assembled position above the substrate 116, as shown in FIGS. 1 through FIG. 3, the opening 128 extending through the middle portion 126 of the busbar arrangement 114 overlies the intermediary metallized sections 162, 164.

A plurality of semiconductor devices 115 is attached to both of the first and the second additional metallized sections 162, 164 of the substrate 116 that underlies the busbar arrangement 114. For example, the semiconductor devices 115 may be vertical power transistor dies. For a vertical power transistor die, the primary current flow path is between the frontside and backside of the power semiconductor die (out of the page in FIG. 5). In one embodiment, one or more of the semiconductor devices 115 are SiC power MOSFET dies, Si power MOSFET dies, HEMT dies, IGBT dies, JFET dies, etc. In the case of a vertical device, the drain (or collector) terminal (out of view in FIG. 5) at the die backside is attached to the corresponding metallized section 162, 164 of the substrate 116, whereas the gate terminal 166 and the source (or emitter) terminal 168 are at the die frontside and connected to the corresponding central metallized section 154 of the substrate 116 by one or more electrical connectors 170 such as bond wires, a metallic clip, a metallic ribbon, etc.

In FIG. 5, the semiconductor devices 115 attached to the first (left) additional metallized section 162 of the substrate 116 that underlies the busbar arrangement 114 form a first high-side switching subsystem S1 of a switched power circuit such as a half-bridge or full-bridge circuit. The semiconductor devices 115 attached to the second (right) additional metallized section 164 of the substrate 116 form a second high-side switching subsystem S2 of the switched power circuit. The on/off state of both high-side switching subsystems S1, S2 depends on the state of the voltage applied between the gate terminal 168 and the source (or emitter) terminal 170 of the individual semiconductor devices 115. The opening 128 in the busbar arrangement 114 allows for connection of the first connectional component 130 to a central metallized part (e.g., first and second intermediary metallized sections 144, 154) of the substrate 116 underlying the busbar arrangement 114, which provides for a more symmetrical distribution of the gate signal and the source/emitter reference signal to the semiconductor devices 115 attached to metallized sections 162, 164 of the substrate 116 that flank the central metallized part of the substrate 116.

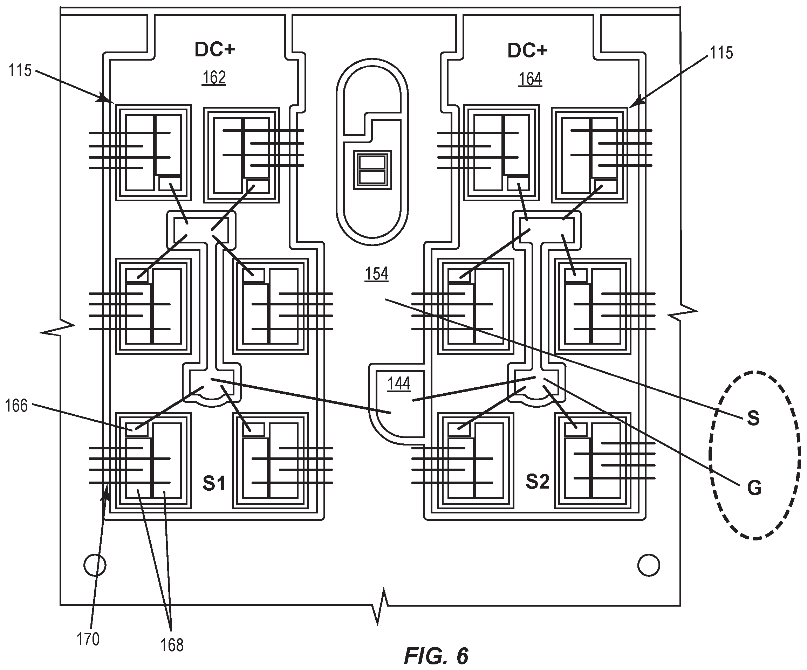

If, instead, the gate and source/emitter signal connections were made at the left or right side of the substrate 116, as schematically represented by the dashed oval in FIG. 6, the gate signal and the source/emitter reference signal to one group of the semiconductor devices 115 (S1 or S2 devices) would be delayed compared to the other group of the semiconductor devices 115. Particularly, the example of one-sided contacting shown in FIG. 6 would result in actuation (turning on or off) of the second high-side switching subsystem S2 before actuation of the first high-side switching subsystem S1, i.e., asymmetrical switching. As such, the configuration shown in FIG. 6 yields a pair of high-side switching subsystems (S1, S2) with significantly different parasitic elements, and thus asymmetric switching behavior. To correct for this, additional wiring must be made in the center of the substrate 116 to avoid asymmetrical switching. However, the additional wiring requires either an additive substrate surface or an additional wiring level, e.g. in the form of an attached, small substrate. Both of these options increase module cost and complexity.

The opening 128 in the busbar arrangement 114 obviates these problems, by enabling gate and source/emitter signal connections the central metallized part (e.g., first and second intermediary metallized sections 144, 154) of the substrate 116 underlying the busbar arrangement 114. Accordingly, the intermediary metallized sections 144, 154 of the underlying substrate 116 symmetrically distribute the gate signal and the reference (source/emitter) signal to the semiconductor devices 166 attached to metallized sections 162, 164 of the substrate 116 that flank the central metallized part of the substrate 116, ensuring symmetrical switching behavior of the high-side switching subsystems S1, S2 of the power circuit.

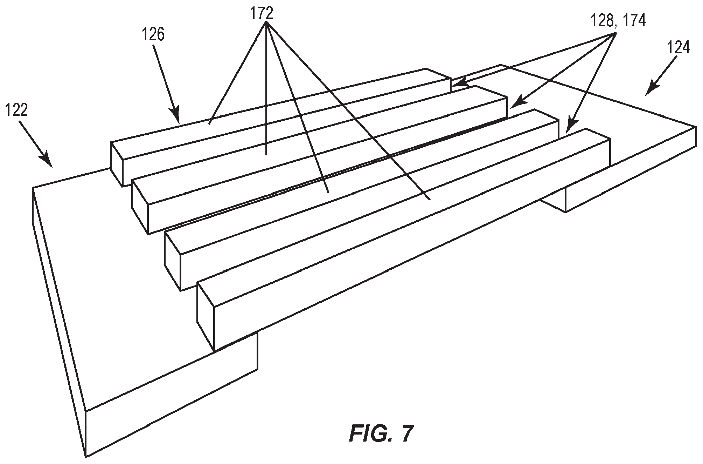

The number of openings 128 in the busbar arrangement 114 can be varied without departing from the underlying concept of the present disclosure. For example, several symmetrically installed openings 128 may be used in place of the single opening 128 illustrated in FIG. 1 through FIG. 4. Separately or in combination, opening(s) 128 in the busbar arrangement 114 may be created by assembling the busbars 106, 110 from several individual parts in the form of spaced apart segments 172, e.g., as shown in FIG. 7. According to this embodiment, each opening 128 extending through the middle portion 126 of the busbar arrangement 114 is formed by a gap 174 between adjacent ones of the spaced apart segments 172.

Returning to FIG. 3, the busbar arrangement 114 includes a lower busbar 176 and an upper busbar 178 overlying and spaced from the lower busbar 176. Part of the housing material separates the lower and upper busbars 176, 178 from each other, so that insulation requirements (accounting for both clearance and creepage distances) are maintained. The opening 128 extending through the middle portion 126 of the busbar arrangement 114 extends through both the lower busbar 176 and the upper busbar 178. The opening 128 in the middle portion 126 of the busbar arrangement 114 may extend through both the lower busbar 176 and the upper busbar 178 in vertical alignment. One of the lower busbar 176 and the upper busbar 178 may be configured for a positive DC potential (DC+), and the other one of the lower busbar 176 and the upper busbar 178 may be configured for a negative DC potential (DC-).

For example, as shown in FIG. 2, the semiconductor devices 115 attached to the substrate 116 that underlies the busbar arrangement 114 may form a high-side switch device of a switched power circuit such as a half-bridge or full-bridge circuit, e.g., as shown in more detail in FIG. 5. According to this embodiment, the semiconductor devices 115 attached to the second substrate 118 laterally adjacent the first substrate 116 form a low-side switch device of the switched power circuit. For example, the semiconductor devices 115 attached to the second substrate 118 may be vertical power transistor dies such as SiC power MOSFET dies, Si power MOSFET dies, HEMT dies, IGBT dies, JFET dies, etc.

A busbar 180 connected to the second substrate 118 extends outside the housing 102 at a side of the housing 102 opposite the second end 124 of the busbar arrangement 114. The middle portion 126 of the busbar arrangement 114 overlies the first substrate 116 but not the second substrate 118. A second connectional component 182 connected to the second substrate 118 extends outside the housing 102 and is configured to carry at least one of a control (e.g., gate) signal and a reference (e.g., source/emitter) signal for the semiconductor devices 115 attached to the second substrate 118. The second connectional component 182 may include pin-type terminals as shown in FIGS. 1, 2 and 4. Other types of connectional components are contemplated, too, such as a metallic clips, a flex PCB, etc.

As illustrated in FIGS. 1, 2 and 4, the first end 122 of the busbar arrangement 114 may be connected to the second substrate 118. In one embodiment, the busbar arrangement 114 may be configured to carry one of a positive DC power signal and a negative DC power signal to the first substrate 116, and carry the other one of the positive DC power signal and the negative DC power signal to the second substrate 118. For example, if the semiconductor devices 115 attached to the substrate 116 that underlies the busbar arrangement 114 form a high-side switch device of a switched power circuit and the semiconductor devices 115 attached to the second substrate 118 form a low-side switch device of the switched power circuit, the busbar arrangement 114 may be configured to carry a positive DC power signal to the first substrate 116 and carry the negative DC power signal to the second substrate 118. The busbar 180 that extends outside the housing 102 at the side of the housing 102 opposite the second end 124 of the busbar arrangement 114 may be configured to carry a switched power signal. In this example, the switched power signal is the signal at the switched node of the half-bridge circuit. Still other power circuit configurations are contemplated and that would benefit from the symmetric switching behavior realized by providing an opening 128 in the busbar arrangement 114 that enables connections to one or more intermediary metallized sections 144, 154 of the underlying substrate 116.

As best illustrated in FIGS. 3 and 4, the sidewall 184 that delimits the opening 128 in the busbar arrangement 114 may comprise an electrically insulative material. According to one embodiment, the electrically insulative material is part of the housing 102. For example, the sidewall 184 that delimits the opening 128 may be formed by overmolding with plastic. However, the electrically insulative material that delimits the opening 128 in the busbar arrangement 114 may comprise a different material than the housing 102. For example, an electrically insulative ring, gasket or similar component may be inserted into the opening 128 in the busbar arrangement 114 to electrically insulate the sidewall 184 of the opening 128. In each case, the electrically insulative material covers the exposed side face 186, 188 of both busbars 176, 178, so that insulation requirements (accounting for both clearance and creepage distances) are maintained.

In one embodiment, the electrically insulative material that forms the sidewall 184 that delimits the opening 128 in the busbar arrangement 114 includes a first flange 190 adjoining the lower busbar 176 of the busbar arrangement 114 and a second flange 192 spaced inward from the first flange 190. The inner diameter D1 of the first flange 190 is greater than the inner diameter D2 of the second flange 192. Separately or in combination, the second flange 192 vertically extends beyond an upper metallic surface 194 of the busbar arrangement 114.

While the figures show only embodiments in which control and/or reference pin contacts extend through the opening 128 in the busbar arrangement 114, other embodiments are also contemplated. For example, the opening 128 could also be used for the passage of sensor signals, fiberoptic cables, PCBs, flex PCBs, cables, punched grids, and other structures.

While the busbar arrangement 114 is illustrated here as being composed of sheet metal conductors, alternatives such as laminated busbars, high-current PCBs, flex PCBs or other commercially available solutions are also contemplated here.

The position of the opening 128 in a symmetrically mounted position in the middle of the busbar arrangement 114 also has the advantage that only weak magnetic fields of the busbars 176, 178 are generated within the opening 128. This prevents coupling to the control signals, which has a positive effect on the switching behavior. This also ensures symmetrical current flow within the busbar structure, with spatial distribution of the magnetic fields that form a local distribution of the inductance.

Although the present disclosure is not so limited, the following numbered examples demonstrate one or more aspects of the disclosure.

Example 1. A semiconductor module arrangement, comprising: a housing; a first substrate positioned at a bottom of the housing; a busbar arrangement having a first end connected to the first substrate, a second end extending outside the housing, and a middle portion spaced from and extending parallel to the first substrate, the middle portion comprising an opening extending therethrough; and a first connectional component having a first end connected to the first substrate, a second end extending outside the housing, and a middle portion extending through the opening in the middle portion of the busbar arrangement.

Example 2. The semiconductor module arrangement of example 1, wherein the busbar arrangement comprises a lower busbar and an upper busbar overlying and spaced from the lower busbar, and wherein the opening extending through the middle portion of the busbar arrangement extends through both the lower busbar and the upper busbar.

Example 3. The semiconductor module arrangement of example 2, wherein one of the lower busbar and the upper busbar is configured for a positive DC potential, and wherein the other one of the lower busbar and the upper busbar is configured for a negative DC potential.

Example 4. The semiconductor module arrangement of example 2 or 3, wherein the opening in the middle portion of the busbar arrangement extends through both the lower busbar and the upper busbar in vertical alignment.

Example 5. The semiconductor module arrangement of any of examples 1 through 4, wherein a sidewall that delimits the opening in the busbar arrangement comprises an electrically insulative material.

Example 6. The semiconductor module arrangement of example 5, wherein the electrically insulative material is part of the housing.

Example 7. The semiconductor module arrangement of any of examples 1 through 6, wherein a sidewall that delimits the opening in the busbar arrangement comprises: a first flange; and a second flange spaced inward from the first flange.

Example 8. The semiconductor module arrangement of example 7, wherein the second flange vertically extends beyond an upper metallic surface of the busbar arrangement.

Example 9. The semiconductor module arrangement of any of examples 1 through 8, wherein the middle portion of the busbar arrangement comprises a plurality of spaced apart segments, and wherein the opening extending through the middle portion of the busbar arrangement is formed by a gap between adjacent ones of the spaced apart segments.

Example 10. The semiconductor module arrangement of any of examples 1 through 9, further comprising: a first plurality of semiconductor dies attached to a first metallized section of the first substrate; and a second plurality of semiconductor dies attached to a second metallized section of the first substrate, wherein the first end of the first connectional component is connected to an intermediary metallized section of the first substrate that is symmetrically flanked by the first metallized section and the second metallized section, wherein the opening extending through the middle portion of the busbar arrangement overlies the intermediary metallized section.

Example 11. The semiconductor module arrangement of example 10, wherein the first connectional component is configured to carry at least one of a control signal and a reference signal for the first plurality of semiconductor dies and the second plurality of semiconductor dies.

Example 12. The semiconductor module arrangement of example 11, wherein the intermediary metallized section of the first substrate is configured to symmetrically distribute the at least one of the control signal and the reference signal to the first plurality of semiconductor dies and the second plurality of semiconductor dies.

Example 13. The semiconductor module arrangement of any of examples 1 through 12, wherein the first connectional component comprises: a first pin-type terminal having a first end connected to a first intermediary metallized section of the first substrate, a second end extending outside the housing, and a middle portion extending through the opening in the middle portion of the busbar arrangement; and a second pin-type terminal having a first end connected to a second intermediary metallized section of the first substrate, a second end extending outside the housing, and a middle portion extending through the opening in the middle portion of the busbar arrangement, wherein the first intermediary metallized section and the second intermediary metallized section are electrically isolated from one another.

Example 14. The semiconductor module arrangement of any of examples 1 through 13, wherein the first end of the first connectional component is connected to a central metalized section of the first substrate that is symmetrically flanked by first and second additional metallized sections of the first substrate.

Example 15. The semiconductor module arrangement of any of examples 1 through 14, further comprising: a second substrate positioned at the bottom of the housing and laterally adjacent the first substrate; and a busbar connected to the second substrate and extending outside the housing at a side of the housing opposite the second end of the busbar arrangement, wherein the middle portion of the busbar arrangement overlies the first substrate but not the second substrate.

Example 16. The semiconductor module arrangement of example 15, further comprising: a first plurality of semiconductor dies attached to the first substrate; a second plurality of semiconductor dies attached to the second substrate; and a second connectional component connected to the second substrate and extending outside the housing, wherein the first connectional component is configured to carry at least one of a control signal and a reference signal for the first plurality of semiconductor dies, wherein the second connectional component is configured to carry at least one of a control signal and a reference signal for the second plurality of semiconductor dies.

Example 17. The semiconductor module arrangement of example 15 or 16, wherein the first end of the busbar arrangement is connected to the second substrate.

Example 18. The semiconductor module arrangement of example 17, wherein the busbar arrangement is configured to carry one of a positive DC power signal and a negative DC power signal to the first substrate and carry the other one of the positive DC power signal and the negative DC power signal to the second substrate.

Example 19. The semiconductor module arrangement of example 18, wherein the busbar is configured to carry a switched power signal from the second substrate.

Example 20. The semiconductor module arrangement of any of examples 1 through 19, wherein the first connectional component comprises a pin-type terminal attached to a central metallized section of the first substrate or received in a metallic sleeve attached to the central metallized section.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to cover all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor module arrangement (100), comprising:
a housing (102);
a first substrate (116) positioned at a bottom of the housing (102);
a busbar arrangement (114) having a first end (122) connected to the first substrate (116), a second end (124) extending outside the housing (102), and a middle portion (126) spaced from and extending parallel to the first substrate (116), the middle portion (126) comprising an opening (128) extending therethrough; and
a first connectional component (130) having a first end connected to the first substrate (116), a second end extending outside the housing (102), and a middle portion extending through the opening (128) in the middle portion (126) of the busbar arrangement (114).

2. The semiconductor module arrangement (100) of claim 1, wherein the busbar arrangement (114) comprises a lower busbar (176) and an upper busbar (178) overlying and spaced from the lower busbar (176), and wherein the opening (128) extending through the middle portion (126) of the busbar arrangement (114) extends through both the lower busbar (176) and the upper busbar (178).

3. The semiconductor module arrangement (100) of claim 2, wherein one of the lower busbar (176) and the upper busbar (178) is configured for a positive DC potential, and wherein the other one of the lower busbar (176) and the upper busbar (178) is configured for a negative DC potential.

4. The semiconductor module arrangement (100) of claim 2, wherein the opening (128) in the middle portion (126) of the busbar arrangement (114) extends through both the lower busbar (176) and the upper busbar (178) in vertical alignment.

5. The semiconductor module arrangement (100) of claim 1, wherein a sidewall (184) that delimits the opening (128) in the busbar arrangement (114) comprises an electrically insulative material.

6. The semiconductor module arrangement (100) of claim 5, wherein the electrically insulative material is part of the housing (102).

7. The semiconductor module arrangement (100) of claim 1, wherein a sidewall (184) that delimits the opening (128) in the busbar arrangement (114) comprises:
a first flange (190); and
a second flange (192) spaced inward from the first flange (190).

8. The semiconductor module arrangement (100) of claim 7, wherein the second flange (192) vertically extends beyond an upper metallic surface of the busbar arrangement (114).

9. The semiconductor module arrangement (100) of claim 1, wherein the middle portion (126) of the busbar arrangement (114) comprises a plurality of spaced apart segments (172), and wherein the opening (128) extending through the middle portion (126) of the busbar arrangement (114) is formed by a gap (174) between adjacent ones of the spaced apart segments (172).

10. The semiconductor module arrangement (100) of claim 1, further comprising:
a first plurality of semiconductor dies attached to a first metallized section of the first substrate (116); and
a second plurality of semiconductor dies attached to a second metallized section of the first substrate (116),
wherein the first end of the first connectional component (130) is connected to an intermediary metallized section of the first substrate (116) that is symmetrically flanked by the first metallized section and the second metallized section,
wherein the opening (128) extending through the middle portion (126) of the busbar arrangement (114) overlies the intermediary metallized section.

11. The semiconductor module arrangement (100) of claim 10, wherein the first connectional component (130) is configured to carry at least one of a control signal and a reference signal for the first plurality of semiconductor dies and the second plurality of semiconductor dies.

12. The semiconductor module arrangement (100) of claim 11, wherein the intermediary metallized section of the first substrate (116) is configured to symmetrically distribute the at least one of the control signal and the reference signal to the first plurality of semiconductor dies and the second plurality of semiconductor dies.

13. The semiconductor module arrangement (100) of claim 1, wherein the first connectional component (130) comprises:
a first pin-type terminal (138) having a first end connected to a first intermediary metallized section of the first substrate (116), a second end extending outside the housing (102), and a middle portion extending through the opening (128) in the middle portion (126) of the busbar arrangement (114); and
a second pin-type terminal (140) having a first end connected to a second intermediary metallized section of the first substrate (116), a second end extending outside the housing (102), and a middle portion extending through the opening (128) in the middle portion (126) of the busbar arrangement (114),
wherein the first intermediary metallized section and the second intermediary metallized section are electrically isolated from one another.

14. The semiconductor module arrangement (100) of claim 1, wherein the first end of the first connectional component (130) is connected to a central metalized section of the first substrate (116) that is symmetrically flanked by first and second additional metallized sections of the first substrate (116).

15. The semiconductor module arrangement (100) of claim 1, further comprising:
a second substrate positioned at the bottom of the housing (102) and laterally adjacent the first substrate (116); and
a busbar connected to the second substrate and extending outside the housing (102) at a side of the housing (102) opposite the second end of the busbar arrangement (114),
wherein the middle portion (126) of the busbar arrangement (114) overlies the first substrate (116) but not the second substrate.
